Europäisches Patentamt

European Patent Office

Office européen des brevets

(11) Numéro de publication: **0 363 286 B1**

(12) FASCICULE DE BREVET EUROPEEN

(45) Date de publication de fascicule du brevet: **10.11.93**

(51) Int. Cl.5: **C22C 29/00**, C22C 32/00, C22C 1/09, H01L 23/14

(21) Numéro de dépôt: **89420334.8**

(22) Date de dépôt: **11.09.89**

Le dossier contient des informations techniques présentées postérieurement au dépôt de la demande et ne figurant pas dans le présent fascicule.

(54) **Matériau pour composants électroniques et procédé d'obtention desdits composants.**

(30) Priorité: **13.09.88 FR 8812548**

(43) Date de publication de la demande:
**11.04.90 Bulletin 90/15**

(45) Mention de la délivrance du brevet:
**10.11.93 Bulletin 93/45**

(84) Etats contractants désignés:
**AT BE CH DE ES FR GB GR IT LI LU NL SE**

(56) Documents cités:
EP-A- 0 045 510          EP-A- 0 048 768
EP-A- 0 110 064          EP-A- 0 170 396
EP-A- 0 178 046          EP-A- 0 253 444
US-A- 3 889 348

WPIL, FILE SUPPLIER, AN=89-140190, Derwent Publications Ltd, Londres, GB;& JP-A-01 083 634 (SUMITOMO) 29-03-1989

PATENT ABSTRACTS OF JAPAN, vol. 13, no. 290 (C-614), 5 juillet 1989;& JP-A-01 083 634 (SUMITOMO ELECTRIC IND. LTD) 29-03-1989

(73) Titulaire: **PECHINEY RECHERCHE
(Groupement d'Intérêt Economique régi par l'ordonnance du 23 Septembre 1967)
23, rue Balzac
F-75008 Paris(FR)**

(72) Inventeur: **Dermarkar, Salim
La Faverge
F-38960 St Etienne de Crossey(FR)**
Inventeur: **Dumant, Xavier
18, rue du Pré d'Elle
F-38240 Meylan(FR)**
Inventeur: **Lebailly, Michel
Chemin J.M. Calvier
Les Charagons
F-84500 Bollene(FR)**

(74) Mandataire: **Vanlaer, Marcel et al
PECHINEY
28, rue de Bonnel
F-69433 Lyon Cédex 3 (FR)**

PATENT ABSTRACTS OF JAPAN, vol. 9, no. 306 (C-317), 3 décembre 1985;& JP-A-60 145 340 (TOUHOKU DAIGAKU KINZOKU ZAI-RIYOUKENKIYUU SHIYOCHIYOU) 31-07-1985

PATENT ABSTRACTS OF JAPAN, vol. 8, no. 218 (C-245), 4 octobre 1984;& JP-A-59 100 235 (NIPPON CARBON K.K.) 09-06-1984

PATENT ABSTRACTS OF JAPAN, vol. 12, no. 56 (C-477), 19 février 1988;

& JP-A-62 199 740 (KOBE STEEL LTD) 03-09-1987

PATENT ABSTRACTS OF JAPAN, vol. 10, no. 145 (E-407), 28 mai 1986;& JP-A-61 007 637 (FURUKAWA DENKI KOGYO K.K.) 14-01-1986

IDEM

## Description

L'invention concerne un matériau pour composants électroniques ayant une conductivité thermique élevée, une masse volumique faible, une dilatabilité faible et un procédé d'obtention desdits composants utilisant ce matériau.

Il faut entendre ici par matériau pour composants électroniques plus particulièrement les matériaux destinés à réaliser des structures telles que fonds dissipateurs, des supports et des pièces polaires de circuits de puissance, des supports de diodes laser, des drains thermiques et des boîtiers d'encapsulation de circuits hybrides de micro-électronique de puissance ou de circuits hyperfréquence. Le terme électronique inclut également ce qui est en rapport avec l'optoélectronique.

Il est connu que dans les dits composants, ces matériaux sont généralement associés à des substrats isolants en céramique tels que l'alumine par exemple ou a des semi-conducteurs tels que le silicium ou l'arséniure de gallium.

Quand ces composants comportent des éléments de puissance, leur fonctionnement conduit à un dégagement de chaleur important. Il est donc nécessaire pour ne pas les détériorer par un échauffement exagéré de dissiper les calories émises le plus rapidement possible. Pour cela, on met en oeuvre un matériau de conductivité thermique $\lambda$ élevée c'est-à-dire au moins supérieure à 60 W.m$^{-1}$ .K$^{-1}$.

Malgré tout, il se produit une élévation de température et si le coefficient de dilatation $\alpha$ du matériau est trop différent de celui du substrat en alumine, il se développe dans ce dernier des contraintes supérieures à la résistance de la céramique d'où des ruptures qui nuisent à la conductivité de l'ensemble et à son isolement électrique. C'est pourquoi, il faut également que le matériau ait un coefficient compatible avec celui de l'alumine et de préférence inférieur à 16.10$^{-6}$ K$^{-1}$ dans l'intervalle de température 30-400 °C.

Par ailleurs, l'utilisation éventuelle de ces circuits dans des véhicules mus par une source d'énergie conduit à rechercher des matériaux ayant une masse volumique la plus faible possible et de préférence inférieure à 3000 kg.m$^{-3}$ afin de réduire le plus possible la consommation d'énergie nécessaire à leur propulsion.

En outre, comme les circuits sont sensibles à l'environnement, on souhaite que le matériau présente un caractère amagnétique convenable ainsi qu'une bonne étanchéité au milieu extérieur.

La réalisation d'un matériau présentant un compromis entre toutes ces propriétés a fait l'objet de nombreuses recherches qui ont abouti à des solutions plus ou moins intéressantes.

Ainsi, on s'est tourné vers des matériaux comme l'acier, le beryllium, certains alliages d'aluminium en raison de leur bonne conductivité ; mais la valeur relativement importante de leur module d'élasticité et de leur dilatabilité nécessite le recours à des joints ou des adhésifs capables d'accommoder la différence de dilatabilité de l'alumine et cela conduit à une réduction de conductivité thermique de l'ensemble.

On s'est alors orienté vers des matériaux présentant une faible dilatabilité comme le kovar (alliage de fer-nickel-cobalt) ou le molybdène ou encore des matériaux multi-métaux du type cuivre/invar/cuivre et également le titane et ses alliages. Mais, à part le molybdène, tous ces matériaux sont fortement pénalisés par une faible conductivité notamment dans le sens perpendiculaire au plan du substrat. Tous ont également une masse volumique élevée dont la plus faible, celle du titane, est de l'ordre de 4500 kg.m$^{-3}$. Par ailleurs, le molybdène est cher et difficile à mettre en oeuvre à cause de sa mauvaise résistance à l'oxydation ; quant au kovar, son usinage est délicat car il se tord sous l'effet de contraintes internes et de nombreux recuits sont nécessaires si on veut le travailler correctement.

On s'est aussi tourné vers d'autres matériaux tels que ceux décrits dans le document JP-A-01 083 634 et qui sont constitués par un alliage composite ayant un coefficient de dilatation compris entre 5 et 11 10$^{-6}$/°C et une conductivité thermique à l'ambiante comprise entre 0, 1 et 0,3 cal/cm.sec.°C, le dit alliage contenant 30 à 70% en volume et au moins un composé sous forme de poudre, de fibres courtes ou de whiskers choisis parmi le nitrure d'aluminium, le carbure de silicium, le nitrure de bore et le graphite, le solde étant constitué essentiellement par de l'aluminium.

Dans ces matériaux, les particules ont de préférence un diamètre moyen inférieur à 10 $\mu$m.

Par ailleurs, ces matériaux sont obtenus en mélangeant les composants à l'état divisé et en les mettant en forme par compression à chaud.

On constate ainsi à la lecture du tableau 3 de ce document que pour un alliage contenant 50 % de fibres courtes de graphite, le coefficient de dilatation est de 10 x 10$^{-6}$/°C et la conductivité thermique de 0,22 cal/cm/sec.°C (soit 91 W.m$^{-1}$ K$^{-1}$) et pour un alliage contenant 60 % de whiskers de SiC, ces caractéristiques sont respectivement 8,3 x 10$^{-6}$/°C et 0,05 cal/cm/.sec.°C (soit 63 W . m$^{-1}$ . K$^{-1}$).

La demanderesse, consciente que les matériaux utilisés jusqu'à présent possédaient des lacunes, a cherché à mettre au point un nouveau matériau qui réalise le compromis de propriétés suivant :

3

- coefficient de dilatation faible et en tout cas compatible avec celle d'une céramique comme l'alumine, le silicium ou l'arséniure de gallium, lors d'une variation de température, pouvant aller jusqu'à 400°C .
- conductibilité thermique la plus élevée possible ;
- masse volumique aussi petite que possible ;
- étanchéité à l'environnement ;
- bonne résistance à la corrosion ;
- usinabilité convenable ;
- aptitude au nickelage ;
- possibilité de soudage ;
- caractére amagnétique.

Ses recherches ont abouti à un matériau pour composants électroniques présentant dans au moins deux directions un coefficient de dilatation $\alpha$ moyen entre 30°C et 250°C compris entre $2.10^{-6}$ .$K^{-1}$ et $13.10^{-6}$.$K^{-1}$, une masse volumique inférieure à 3000 kg.$m^{-3}$ et une conductivité thermique $\lambda$ supérieure ou égale à 113 W.$m^{-1}$ . $K^{-1.}$ caractérisé en ce qu'il est réalisé en un produit composite formé d'une matrice en un métal choisi parmi l'aluminium pur, le magnésium pur et leurs alliages et par des éléments de renforcement choisis parmi

- les particules de graphite artificiel suivant une fraction volumique comprise entre 60 et 90 %,
- les particules de carbure de silicium, de nitrure de silicium et de nitrure d'aluminium suivant une fraction volumique comprise entre 40 et 85% et une taille moyenne comprise entre 17,3 et 50 $\mu$m,
- les fibres courtes de carbone graphité en proportion volumique comprise entre 15 et 30%,

ledit produit résultant de l'infiltration de l'élément de renforcement par le métal à l'état liquide.

Ainsi, le matériau selon l'invention diffère des précédents en ce qu'il n'est plus uniquement constitué par un ou plusieurs métaux disposés en sandwich, mais par des mélanges polyphasés de fibres ou de particules réparties convenablement dans une matrice métallique.

Cette matrice peut être de l'aluminium pur, du magnésium pur ou leurs alliages. En effet, ces métaux combinent une bonne conductivité, une faible densité et un bas point de fusion.

Les alliages sont choisis en fonction de leur conductivité sachant que la valeur de cette propriété décroît en fonction de la nature et de la quantité des éléments d'addition et qu'elle décroît plus quand les dits éléments sont en solution solide que lorsqu'ils sont présents sous forme de précipités.

Dans le cas des alliages d'aluminium, on utilise ceux qui sont peu chargés en éléments d'addition : le zinc, le cuivre, le magnésium, le fer et le nickel peuvent être tolérés en faible quantité ; quant au manganèse, au titane, au vanadium et au lithium, ils sont à éviter.

De préférence, on choisit les alliages des séries 1000, 5000 et 6000 suivant les normes de l'Aluminium Association, ainsi que des alliages de moulage de la série 4000 et plus particulièrement parmi ces derniers, ceux renfermant 7, 10 et 13% de silicium, tels les alliages AA 356, AA 357 et AA 413.2 et parmi ceux de la série 6000, les alliages 6061 et 6101.

Dans certains cas, on tient compte de la limite d'élasticité de l'alliage car ce facteur a une influence sur le comportement en dilatation du matériau composite et plus particulièrement quand l'élément de renforcement est sous forme fibreuse (continue ou non).

Ainsi, sur des composites unidirectionnels contenant 50% de fibres de carbone du type T300 de la Société TORAY en utilisant différentes matrices telles que l'aluminium pur (1050), l'aluminium contenant en poids 2% de magnésium et l'aluminium contenant 5% de zinc, 2% de magnésium et 2% de cuivre, on constate lors d'une montée en température de 30 à 400°C, des déformations respectives de 0,02%, 0,04% et 0,15% et les phénomènes suivants se produisent pendant que la matrice et la fibre sont en déformation élastique, la dilatation est linéaire. En même temps, du fait de la différence de dilatation entre les fibres et la matrice, il se crée des contraintes thermiques dans le composite lors d'une élévation de température. A partir d'une certaine température, ces contraintes atteignent la limite d'élasticité de la matrice et il y a écoulement plastique de la matrice.

La dilatation dans le sens des fibres est alors principalement gouvernée par les éléments de renforcement et devient très faible. Le phénomène est particulièrement marqué dans le cas de fibres présentant un faible coefficient de dilatation comme les fibres de carbone.

Pour avoir un matériau de plus faible dilatabilité, on a donc intérêt à choisir une matrice présentant une faible limite d'élasticité, comme l'aluminium par exemple. D'autre part, on peut souhaiter éviter un endommagement en cyclage thermique. Il suffit alors de choisir un alliage présentant une limite d'élasticité suffisante sur la gamme de température considérée.

Les propriétés mécaniques de la matrice métallique peuvent être améliorées par des traitements thermiques tels que le recuit ou le revenu, opérations particulièrement intéressantes dans le cas des alliages 6000 et les alliages AA 356 et AA 357.

Le matériau selon l'invention est constitué également par des éléments de renforcement sous forme de particules équiaxes ou plates et/ou de fibres.

Tous les éléments de renforcement n'ont pas la même efficacité et ont recourt, de préférence, à ceux qui ont une faible dilatabilité, un module d'élasticité élevé, une conductivité thermique élevée et une masse volumique faible.

En particulier, on utilise du carbure de silicium, du nitrure de silicium, du nitrure d'aluminium, et du graphite. Plus spécifiquement, on utilise du carbure de silicium qui présente un excellent compromis de propriétés.

En ce qui concerne les particules, elles ont une taille comprise entre 17, 3 et 50 $\mu$m. La limite supérieure de la taille des particules est fixée par la rugosité acceptable pour l'application.

La taille moyenne des particules a une limite inférieure car l'usinabilité augmente lorsque la taille des particules diminue. De plus, il est difficile d'imprégner des particules de petite taille par du métal liquide notamment l'aluminium.

Si l'élément de renforcement est le carbone partiellement ou totalement graphité, il n'y a pas de limite supérieure à la taille car l'usinabilité est toujours excellente.

Ces éléments peuvent être utilisés sous diverses formes :
- soit sous forme de préformes poreuses agglomérées de particules, notamment dans le cas du carbure de silicium ;
- soit sous forme agglomérée ; dans le cas des produits carbonés par exemple, on peut utiliser des structures poreuses agglomérées graphitées à haute température (graphite articifiel).

Quant aux fibres, on met en oeuvre des préformes ou des feutres de fibres courtes de carbone graphité et orientées dans le plan de la plaque de feutre.

La quantité d'éléments de renforcement est fixée de façon à obtenir le compromis entre les propriétés visées pour le matériau. Plus la fraction volumique en éléments est faible, plus le composite se dilate sous l'action de la température.

L'invention concerne également un procédé d'obtention de composants électroniques à partir de matériaux ayant les caractéristiques de la revendication 1 caractérisé en ce que :
- l'on place dans un moule une masse poreuse d'éléments de renforcement choisie parmi les particules de carbure de silicium de nitrure de silicium et de nitrure d'aluminium suivant une fraction volumique comprise entre 40 et 85% et une taille moyenne comprise entre 17,3 et 50 $\mu$m, les particules de graphite artificiel suivant une proportion volumique comprise entre 60 et 90% et les fibres courtes de carbone graphité en proportion volumique comprise entre 15 et 30%.
- l'on infiltre la dite masse par le métal à l'état liquide choisi parmi l'aluminim pur, le magnésium pur et leurs alliages de manières à obtenir un matériau présentant dans au moins deux directions un coefficient $\alpha$ entre 30 et 250°C compris entre 2 et 13 $10^{-6}$ $K^{-1}$ une masse volumique inférieure à 3000 kf. $m^{-3}$, et une conductivité $\lambda$ supérieure à 113 W $m^{-1}$ $K^{-1}$.
- l'on récupère le matériau obtenu après solidification
- l'on réalise une structure de liaison, d'encapsulation ou de support formée au moins en partie par le dit matériau
- l'on y associe des éléments semi-conducteurs ou des isolants.
- l'on met en place des circuits actifs et assure les interconnections.

Ainsi le procédé selon l'invention consiste d'abord à placer une masse poreuse d'éléments de renforcement dans un moule.

Ces éléments sont choisis pour leur faible coefficient de dilatation et leur forte conductivité thermique : carbure de silicum et graphite de préférence. Le choix de la morphologie de cette masse est fait en fonction du caractère isotrope ou anisotrope des fonctions de dilatation et/ou de conductivité de la structure. Lorsque cette dernière nécessite des propriétés de dilatation et/ou de conductivité isotropes, la masse poreuse est réalisée à partir de préformes agglomérées de particules.

Ensuite, cette masse est infiltrée par le métal liquide suivant des techniques connues de l'homme de l'art (voir par exemple A.G. KELLY et G.I. DAVIES, Metallurgical Reviews, 1965, Vol. 10 n°37), qui peuvent nécessiter l'utilisation d'une pression appliquée et/ou d'un préchauffage ; mais toute autre technique d'imprégnation ou de moulage connue peut être mise en oeuvre (voir les brevets US 4376804 et US 4777998, EP 0105890 et EP 045510 par exemple).

Dans le cas de matrice métallique constituée par un alliage de la série 6000 et des alliages AA 356 et AA 357 et tout alliage pouvant donner lieu à durcissement structural, on fait subir au matériau après moulage, un traitement thermique du type recuit ou revenu pour améliorer ses propriétés mécaniques.

Après solidification du matériau, celui-ci va servir à réaliser une structure, pièce de forme particulière suivant l'usage auquel elle est destinée. Ainsi ce peut être soit une structure de liaison permettant de relier

EP 0 363 286 B1

les différentes parties du composant, soit une structure de support sur laquelle seront fixées les autres parties du composant, soit encore une structure d'encapsulation c'est-à-dire permettant d'enfermer de façon plus ou moins hermétique les autres parties du composant.

Dans ce dernier cas, la structure est munie d'ouvertures à travers lesquelles peuvent passer les connections des circuits électroniques actifs, leur passage étant rendu étanche par brasage.

Cette structure est réalisée soit uniquement avec le matériau suivant l'invention, soit en combinaison avec des pièces métalliques non renforcées en aluminium, en magnésium et en leurs alliages car suivant la fonction exercée par la structure il n'est pas toujours nécessaire qu'elle soit homogène.

Cette hétérogénéité peut être obtenue au niveau du moulage : la masse poreuse d'éléments de renforcement étant disposée de façon particulière ou encore en reliant le matériau aux pièces par soudage ou autre moyen de liaison.

La forme de la structure est obtenue soit directement par moulage, soit par moulage puis usinage, soit parfois par simple usinage pour obtenir les cotes finales.

Eventuellement, si les opérations ultérieures de brasage sur le composant sont nécessaires, on fait subir à la structure un traitement de surface par nickelage chimique ou électrochimique.

A cette structure, on associe ensuite des éléments semi-conducteurs ou isolants de préférence par brasage ou par collage et enfin, on place les circuits électroniques actifs de façon à assurer les interconnections des composants avec leur environnement.

Dans le cas particulier où on veut réaliser une structure d'encapsulation, on forme d'abord un boîtier, à l'intérieur duquel sont logés les éléments semi-conducteurs ou les isolants et les circuits actifs, que l'on ferme avec un couvercle qui est fixé par soudobrasage au laser.

Enfin, la réalisation de structures du type drain thermique ou support s'accompagne éventuellement d'une protection par un vernis ou une résine.

L'invention sera mieux comprise à l'aide des figures jointes :

- **Figure 1 :** une vue en coupe verticale d'un composant électronique comprenant une structure en forme de drain thermique pour circuit de puissance.
- **Figure 2 :** une vue de dessus du composant de la figure 1.
- **Figure 3 :** une vue en coupe verticale d'un composant électronique comprenant une structure en forme de boîtier d'encapsulation avec ses connections et son couvercle.
- **Figure 4 :** une vue de dessus du composant de la figure 1, couvercle enlevé.

Plus précisément, on distingue :

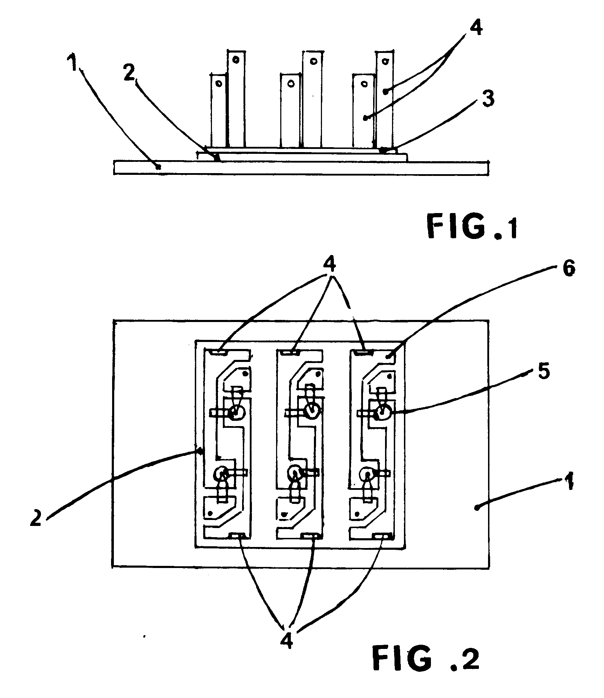

. sur la **figure 1,** un drain thermique 1 réalisé en matériau selon l'invention, sur lequel repose un isolant 2 formé par une couche d'alumine sur lequel est placé un circuit actif 3 relié à l'environnement par les connections 4 d'entrée/sortie.

. sur la **figure 2,** le drain thermique 1, son isolant 2, son circuit actif 3 formé de thyristors 5, des pistes conductrices 6 et leurs connections 4.

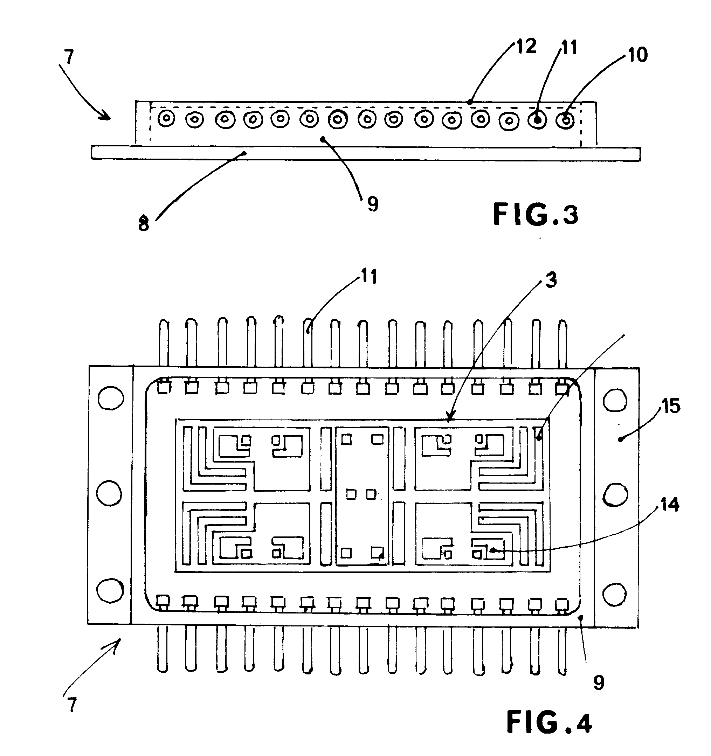

. Sur la **figure 3,** un boîtier 7 réalisé en matériau selon l'invention, formé d'une semelle 8 sur laquelle repose un cadre 9 munie d'ouvertures 10 à travers lesquelles passent les connections 11 des circuits actifs. A l'intérieur du cadre et à sa partie supérieure est fixé un couvercle 12.

- sur la **figure 4,** un boîtier 7 avec sa semelle 8, son cadre 9, ses connections 11. Sur la semelle repose un isolant 13 sur lequel sont placés des circuits actifs 14 comprenant des pistes conductrices 15. Les liaisons entre connections et circuits actifs n'ont pas été représentées

L'invention peut être illustrée à l'aide des exemples d'applications suivants :

## EXEMPLE 1

On a réalisé un matériau composite formé d'une matrice en aluminium 1050 et d'éléments de renforcement sous forme de particules de SiC de pureté supérieure à 99,5% de la manière suivante :

Une préforme de 120 mm de diamètre a été obtenue par filtration d'une suspension de particules de SiC de taille moyenne 44,5 $\mu$m contenant de la silice colloïdale pour assurer sa cohésion. Après séchage, elle contenait en volume 43,6% de particules et 5,5% de silice. Cette préforme a été préchauffée à 800°C pendant une heure sous argon puis placée dans le moule d'une presse dans lequel on a injecté avec une vitesse de 3 m.sec$^{-1}$ et sous une pression de 68 MPa de l'aluminium 1050 préalablement porté à une température de 815°C.

Après solidification et démoulage, on a obtenu un matériau de masse composite volumique de 2910 kg.m$^{-3}$ correspondant à la valeur théorique.

La conductivité thermique de ce matériau composite a été calculée à partir de mesures par la méthode flash de la diffusivité thermique et de la chaleur volumique et a donné pour résultat une valeur de 180

6

$W.m^{-1}.K^{-1}$.

Quant aux mesures du coefficient de dilatation moyen, elles ont donné les chiffres suivants :

$$- 12,5 \times 10^{-6}K^{-1} \qquad \text{entre 30 et 250°C}$$
$$- 14,1 \times 10^{-6}K^{-1} \qquad \text{entre 30 et 400°C}$$

## EXEMPLE 2

On a réalisé un matériau composite formé de la même matrice métallique que dans l'Exemple 1 mais utilisant comme éléments de renforcement des préformes poreuses de brai aggloméré et de coke graphité.

Les mesures effectuées sur les matériaux obtenus ont donné les résultats suivants :
- avec le brai aggloméré :
    . masse volumique : 2140 $kg.m^{-3}$
    . conductivité thermique : 73 $W.m^{-1}.K^{-1}$
    . coefficient de dilatation 10,5 x $10^{-6}K^{-1}$ sensiblement constant entre 30 et 400 ° C.
- avec le coke graphité :
    . masse volumique : 2090 $kg.m^{-3}$
    . conductivité thermique : 146 $W.m^{-1}.K^{-1}$
    . coefficient de dilatation 10 x $10^{-6}K^{-1}$ sensiblement constant entre 30 et 250 ° C.

Le matériau à base de coke est donc plus intéressant que le précédent en raison de sa conductivité élevée.

## EXEMPLE 3

On a réalisé des matériaux composites ayant pour matrice métallique de l'aluminium 1050 et 1090 et à chacune desquelles on a associé des fibres courtes de carbone de 2 types différents :
- des fibres issues d'un précurseur P.A.N. polyacrylonitrile (P.A.N.)
- des fibres issues d'un précurseur P.A.N. mais ayant subi un traitement de graphitation à 2600 ° C.

Les résultats des mesures effectuées sur ces matériaux sont les suivants :

Un matériau composite à matrice 1050, renforcé par 23% en volume de fibres de carbone ex. P.A.N. graphitées à 2600 ° C a une masse volumique de 2500 $kg.m^{-3}$, une conductivité dans le sens perpendiculaire au plan des fibres de 157 $W.m^{-1}.K^{-1}$, un coefficient de dilatation tangent à 30 ° C de l'ordre de $10.10^{-6}K^{-1}$, entre 30 et 250 ° C de l'ordre de $8.10^{-6}K^{-1}$ et entre 30 et 400 ° C de l'ordre de $5.10^{-6}K^{-1}$.

Un matériau composite à matrice 1090, renforcé par 18% en volume de fibres de carbone ex. P.A.N. graphitées à 2600 ° C a une masse volumique voisine de 2500 $Kg.m^{-3}$, une conductivité dans le sens perpendiculaire au plan des fibres de 164 $W.m^{-1}.K^{-1}$, un coefficient de dilatation tangent à 30 ° C de l'ordre de $19.10^{-6}K^{-1}$, entre 30 et 250 ° C de l'ordre de $6,4.10^{-6}K^{-1}$ et entre 30 et 400 ° C de l'ordre de $3.10^{-6}K^{-1}$.

Un matériau composite à matrice 1090, renforcé par 18% en volume de fibres de carbone ex. P.A.N. non graphitées a une masse volumique voisine de 2500 $kg.m^{-3}$, une conductivité dans le sens perpendiculaire au plan des fibres de 91 $W.m^{-1}.K^{-1}$, un coefficient de dilatation tangent à 30 ° C de l'ordre de $18.10^{-6}K^{-1}$, entre 30 et 250 ° C de l'ordre de $8,2.10^{-6}K^{-1}$ et entre 30 et 400 ° C de l'ordre de $5,3.10^{-6}K^{-1}$.

Cet exemple montre l'intérêt d'utiliser des fibres graphitées plutôt que des fibres non graphitées quand on recherche une conductivité élevée.

## EXEMPLE 4

On a réalisé des matériaux composites comprenant un graphite artificiel (référence S2457 du Carbone Lorraine) et différents alliages d'aluminium et de magnésium. Il s'agit d'aluminium de pureté supérieure à 99,7% (A7), d'aluminium contenant 5% de magnésium (AG5), de magnésium contenant 5% de nickel (AN5), d'aluminium contenant 7% de silicium et 0,6% de magnésium (AS7GO,6), de magnésium contenant 5% de zinc et 1% environ de terres rares (RZ5).

Après solidification et démoulage, on a obtenu des matériaux composites dont les propriétés de dilatation, de conductivité thermique, de densité et parfois aussi de flexion, de rigidité et de résistivité électrique ont été déterminées.

Les résultats sont rapportés dans le tableau.

| Matrice | Coefficient de dilatation entre 30 et 250°C | Conductivité Thermique | masse volumique | Module d'Young | Résistance en flexion | Résistivité électrique |
|---|---|---|---|---|---|---|
| | $10^{-6}.K^{-1}$ | $W.m^{-1}.K^{-1}$ | $kg.m^{-3}$ | GPa | Mpa | Microhm-cm |
| A7 | 6,0 | 133 | 2200 | 20 | 58 | 125 |
| AS7G | 7,4 | 142 | 2200 | 23 | 128 | 150 |
| AG5 | 7,9 | 124 | 2200 | - | - | - |
| AN5 | 5,3 | 124 | 2200 | - | - | - |
| RZ5 | 6,5 | 128 | 1700 | - | - | - |

Les différentes compositions d'alliages à base d'aluminium et de magnésium aboutissent à des compromis de propriétés différents. On remarque en particulier que l'on est capable d'obtenir des coefficients de dilatation très proches de ceux de l'alumine, de l'arseniure de gallium, tout en conservant une conductivité thermique très élevée.

**EXEMPLE 5**

On a réalisé des matériaux composites comprenant différents types de graphites artificiels de différentes densités (références S2512 - S2457 - S2545 du Carbone Lorraine) et une matrice d'aluminium de pureté supérieure à 99,7%. La fraction volumique de graphite dans ces composites est comprise entre 50% et 90%.

Après infiltration et démoulage, on a obtenu des composites dont les propriétés de dilatation, de conductivité thermique, de masse volumique et parfois aussi de flexion, de rigidité et de résistivité électrique ont été déterminées.

Les résultats sont rapportés dans le tableau.

| Référence du graphite | Coefficient de dilatation entre 30 et 250°C | Conductivité Thermique | masse volumique | Module d'Young | Résistance en flexion | Résistivité électrique |
|---|---|---|---|---|---|---|
| | $10^{-6}.K^{-1}$ | $W.m^{-1}.K^{-1}$ | $kg.m^{-3}$ | GPa | Mpa | Microhm-cm |
| S2512 | 2,9 | 113 | 2200 | 18 | 72 | - |
| S2457 | 6,0 | 133 | 2200 | 20 | 58 | 125 |
| S2545 | 10,0 | 129 | 2300 | 25 | 32 | 25 |

Les différentes nuances de graphite aboutissent à des compromis de propriétés différents. On remarque en particulier qu'avec la nuance de graphite S2512 on obtient un coefficient de dilatation équivalent à celui du silicium et du nitrure de silicium par exemple.

**EXEMPLE 6**

0n a réalisé un matériau composite formé d'une matrice en aluminium 1070 et de particules de SiC suivant la méthode décrite dans l'exemple 1. Le composite contenait cette fois 51 % en volume de particules de taille moyenne 17,3 $\mu$m. Le composite obtenu a un coefficient de dilatation de $10,0.10^{-6}.K^{-1}$, une conductivité de 116 $W.m^{-1}.K^{-1}$, une masse volumique de 2950 $kg.m^{-3}$, un module d'Young de 125 GPa, une résistance en flexion de 307 MPa et une résistivité électrique de 11 microhm-cm.

**EXEMPLE 7**

Les matériaux décrits dans l'exemple 4 ont été sélectionnés pour leur conductivité thermique élevée et leur faible coefficient de dilatation pour réaliser une structure de type drain thermique de circuit de puissance (Fig. 1 et 2). Le drain thermique (1) a été usiné par les méthodes d'usinage mécanique conventionnelles. Après usinage, le drain thermique a subi un traitement de nickelage chimique conduisant au dépôt d'une couche de nickel de 10 µm d'épaisseur. L'adhérence de la couche de nickel sur le drain a été vérifiée par des essais de choc thermique sur un drain nickelé et dont la couche de nickel a été artificiellement quadrillée. Les dépôts de nickel sont parfaitement adhérents. Le nickelage permet donc de réaliser la brasure avec une plaquette isolante d'alumine (2) qui supporte les pistes conductrices (6), les thyristors (5) et les connections d'entrée/sortie (4). La brasure a été réalisée au moyen d'une brasure Sn-Pb. Aucune déformation du drain thermique après brasure n'a été observée.

## EXEMPLE 8

Les matériaux décrits dans l'exemple 3 ont été sélectionnés pour réaliser une structure composite de type semelle de boîtier d'encapsulation pour hybride de puissance (Fig.3 et 4). La semelle (8) a été usinée par les méthodes d'usinage mécanique aux cotes voulues. Après usinage, la semelle a subi un traitement de nickelage chimique et électrochimique conduisant au dépôt d'une couche de nickel de 15 µm d'épaisseur.

Par ailleurs, un cadre (9) et des entrées/sorties (11) ont été usinés dans un acier de type Fe-Ni-Co présentant une faible dilatation, le cadre pouvant assurer le passage de 30 entrées/sorties.

L'assemblage hermétique et isolé des entrées/sorties sur le cadre est réalisé par un scellement au verre suivant une technique bien connue de l'homme de l'art, impliquant la fusion du verre à une température comprise entre 800°C et 1000°C. L'ensemble cadre (9) + entrées/sorties (11) est alors reporté par une brasure à haute température (300°C à 350°C) de type Au-Ge sur la semelle (8).

Après brasure, on a vérifié :
- la non déformation de la semelle (8)
- la bonne tenue de l'ensemble brasé au choc thermique entre - 55°C et + 125°C
- l'herméticité de l'ensemble avec un débit de fuite inférieur à $1.10^{-8}$ atm.cm$^3$ s$^{-1}$ au moyen d'un détecteur de fuite à l'hélium suivant la norme NFC 20631.

La brasure d'une plaquette d'alumine (13) supportant les pistes conductrices (15) et les circuits actifs (14) est alors réalisée sur la semelle (8) au moyen d'une brasure à basse température de type Sn-Pb, sans déformation ni rupture.

La fermeture du boîtier au moyen d'un couvercle usiné dans le même matériau est réalisée par soudo-brasage au laser, avec une brasure de type Au-Ge. Le caractère très localisé de l'échauffement dans ce type de fermeture permet de ne pas détériorer les brasures antérieures ou à plus basse température.

Initialement, ce boîtier était réalisé avec une semelle en cuivre. Du fait de la présente invention, la masse de ce boîtier peut être divisée par 2.

Dans une variante de cet exemple, une structure monobloc comprenant l'ensemble semelle (8) et cadre (9) est usinée dans les matériaux de l'exemple 4 ; la masse du boîtier est alors divisée par 4. L'assemblage hermétique des entrées/sorties est réalisé par brasage sur des bagues de nickel, après scellement au verre des entrées/sorties sur ces bagues de nickel.

Ces exemples ne sont pas limitatifs, le procédé incluant des combinaisons avec des résines polymères par exemple (support de cartes) ou toute combinaison de liaisons par collage, soudage, assemblage mécanique ou brasage.

Tous les matériaux composites ainsi que les structures composites obtenues à partir de ces matériaux décrits dans les exemples 1 à 8 présentent dans au moins deux directions un coefficient de dilatation moyen entre 30°C et 250°C inférieur à $13.10^{-6}.K^{-1}$ et supérieur à $2.10^{-6}.K^{-1}$.

Le tableau I rappelle les exemples de matériaux et des structures qui satisfont à cette propriété dans toutes les directions (matériaux et structures isotropes). Le tableau II correspond aux matériaux et aux structures qui satisfont à une propriété respectivement dans au moins deux directions (matériaux et structures bidirectionnels).

TABLEAU I

| MATERIAUX ET STRUCTURES ISOTROPES | |
|---|---|
| Composite | Coefficient de dilatation entre 30°C et 250°C ($10^{-6}$ K$^{-1}$) |
| . SiCp / A9 | 12,5 |
| . SiCp / A7 | 10 |
| . Coke graphité / A9 | 10 |
| . Graphite / AG5 Artificiel | 7,9 |
| . Graphite / AS7G artificiel | 7,4 |
| . Graphite / RZ5 artificiel | 6,5 |
| . Graphite / A7 artificiel | 6 |
| . Graphite / AN5 artificiel | 5,3 |
| . Graphite / A7 artificiel | 2,9 |

TABLEAU II

MATERIAUX ET STRUCTURES BIDIRECTIONNELS

| Composite | Coefficient de dilatation dans le plan (x, y) entre 30°C et 250°C |
|---|---|
| . Fibres courtes de carbone non graphitées / A5 * | 8,2 |
| . Fibres courtes de carbone graphitées / A5 | 8 |
| . Fibres courtes de carbone graphitées / A9 | 6,4 |

*: ne Fait pas partie de l'invention

## Revendications

1. Matériau pour composants électroniques présentant dans au moins deux directions, un coefficient de dilatation $\alpha$ centre 30°C et 250°C compris entre 2 et 13.$10^{-6}$ K$^{-1}$, une masse volumique inférieure à 3000 kg.m$^{-3}$ et une conductivité $\lambda$ supérieure ou égale à 113 W.m$^{-1}$.K$^{-1}$ caractérisé en ce qu'il est réalisé en un produit composite formé d'une matrice en un métal choisi parmi l'aluminim pur, le magnésium pur et leurs alliages et par des éléments de renforcement choisis parmi
   - les particules de graphite suivant une fraction volumique comprise entre 60 et 90 % ;

10

- les particules de carbure de silicium, de nitrure de silicium et de nitrure d'aluminium suivant une fraction volumique comprise entre 40 et 85% et une taille moyenne comprise entre 17,3 et 50 μm.
- les fibres courtes de carbone graphité en proportion volumique comprise entre 15 et 30%,

ledit produit résultant de l'infiltration de l'élément de renforcement par le métal à l'état liquide.

2. Matériau selon la revendication 1 caractérisé en ce que les alliages d'aluminium appartiennent au groupe constitué par les séries 1000, 4000, 5000 et 6000 suivant les normes de l'Aluminium Association.

3. Matériau selon la revendication 2, caractérisé en ce que parmi les alliages de la série 4000 figurent les alliages de moulage contenant environ 7, 10 et 13% en poids de silicium et les alliages AA 356, AA357 et AA 413.2.

4. Matériau selon la revendication 1 caractérisé en ce que les éléments de renforcement sont constitués par une préforme poreuse agglomérée de particules de carbure de silicium.

5. Matériau selon la revendication 1 caractérisé en ce que les éléments de renforcement sont constitués par un feutre ou une préforme de fibres courtes de carbone graphité.

6. Procédé d'obtention de composants électroniques à partir de matériaux suivant la revendication 1, caractérisé en ce que :
   - l'on place dans un moule une masse poreuse d'éléments de renforcement choisie parmi les particules de carbure de silicium de nitrure de silicium et de nitrure d'aluminium suivant une fraction volumique comprise entre 40 et 85 % et une taille moyenne comprise entre 17,3 et 50 μm, les particules de graphite artificiel suivant une fraction volumique comprise entre 60 et 90% et les fibres courtes de carbone graphité en proportion volumique comprise entre 15 et 30%.
   - l'on infiltre la dite masse par le métal à l'état liquide choisi parmi l'aluminium pur, le magnésium pur et leurs alliages de manière à obtenir un matériau présentant dans au moins deux directions un coefficient $\alpha$ entre 30 et 250°C compris entre 2 et 13 $10^{-6}$ $K^{-1}$ une masse volumique inférieure à 3000 kg $m^{-3}$ , et une conductivité $\lambda$ supérieure à 113W $m^{-1}$ $K^{-1}$ .
   - l'on récupère le matériau obtenu après solidification
   - l'on réalise une structure de liaison, d'encapsulation ou de support formée au moins en partie par le dit matériau
   - l'on y associe des éléments semi-conducteurs ou des isolants
   - l'on met en place les circuits actifs et assure les interconnections.

7. Procédé selon la revendication 6, caractérisé en ce que la masse ooreuse est choisie parmi les préformes agglomérées de particules, les feutres de fibres courtes, les fibres continues bobinées.

8. Procédé selon la revendication 6, caractérisé en ce que dans le cas d'une matrice constituée par un alliage de la série 6000 et des alliages AA 356 et AA 357, le matériau subit un traitement thermique choisi parmi le recuit et par le revenu.

9. Procédé selon la revendication 6, caractérisé en ce que l'on usine la structure aux cotes finales.

10. Procédé selon la revendication 6, caractérisé en ce que l'on revêt la structure d'une couche de nickel chimique et/ou électrochimique.

11. Procédé selon la revendication 6, caractérisé en ce que l'on associe la structure aux semi-conducteurs et aux isolants par brasage.

12. Procédé selon la revendication 6, caractérisé en ce que l'on associe la structure au semi-conducteurs et aux isolants par collage.

13. Procédé selon la revendication 6, caractérisé en ce que l'on réalise la structure d'encapsulation par soudobrasage au laser, d'un couvercle sur un boîtier préalablement garni avec les éléments semi-conducteurs ou les isolants et les circuits actifs.

**EP 0 363 286 B1**

**14.** Procédé selon la revendication 6, caractérisé en ce que l'on protège les composants par un produit choisi parmi les vernis, les résines.

**Claims**

**1.** A material for electronic components with a coefficient of expansion $\alpha$ from 30°C to 250°C of from 2 to $13.10^{-6}\,K^{-1}$ in at least two directions, a density below 3000 kg.m$^{-3}$ and a conductivity $\lambda$ which is greater than or equal to 113 W.m$^{-1}$.K$^{-1}$, characterised in that it is made of a composite product formed from a matrix of a metal selected from pure aluminium, pure magnesium and their alloys and by reinforcing elements selected from
- graphite particles in accordance with a voluminal fraction of between 60 and 90%;
- particles of silicon carbide, silicon nitride and aluminium nitride in accordance with a voluminal fraction of between 40 and 85% and with an average size of between 17.3 and 50 $\mu$m.
- short fibres of graphited carbon in a voluminal proportion of between 15 and 30%,
said product resulting in infiltration of the reinforcing element by the metal in liquid state.

**2.** A material according to Claim 1, characterised in that the aluminium alloys belong to the group comprising series 1000, 4000, 5000 and 6000, as defined by the Aluminium Association standards.

**3.** A material according to Claim 2, characterised in that the series 4000 alloys include moulding alloys containing about 7, 10 and 13% by weight of silicon and the AA 356, AA357 and AA 413.2 alloys.

**4.** A material according to Claim 1, characterised in that the reinforcing elements comprise a porous preform agglomerated with particles of silicon carbide.

**5.** A material according to Claim 1, characterised in that the reinforcing elements comprise a felt or a preform of short graphited carbon fibres.

**6.** A method of obtaining electronic components from materials according to Claim 1, characterised by:
- placing in a mould a porous mass of reinforcing elements selected from particles of silicon carbide, silicon nitride and aluminium nitride in accordance with a voluminal fraction of between 40 and 85% and of an average size of between 17.3 and 50 $\mu$m, the artificial graphite particles being in a voluminal fraction of between 60 and 90% and the short graphited carbon fibres being in a voluminal proportion of between 15 and 30%.
- infiltration of said mass by the metal in the liquid state selected from pure aluminium, pure magnesium and their alloys in such a way as to obtain a material having a coefficient $\alpha$ between 30 and 250°C of between 2 and 13 10$^{-6}$ K$^{-1}$ in at least two directions, a density less than 3000 kg m$^{-3}$, and a conductivity $\lambda$ above 113W m$^{-1}$ K$^{-1}$.
- recovery of the material obtained after solidification
- making a bonding structure, an encapsulating structure or a supporting structure which is formed at least partly of said material
- joining to it semi-conductor elements or insulators
- positioning active circuits and making interconnections.

**7.** A method according to Claim 6, characterised in that the porous mass is selected from preforms agglomerated with particles, short fibre felts, continuous wound fibres.

**8.** A method according to Claim 6, characterised in that in the case of a matrix constituted of a series 6000 alloy and AA 356 and AA 357 alloys, the material is subjected to a heat treatment selected from annealing and tempering.

**9.** A method according to Claim 6, characterised in that the structure is machined to its final dimensions.

**10.** A method according to Claim 6, characterised in that the structure is coated with a chemical and/or electrochemical layer of nickel.

**11.** A method according to Claim 6, characterised in that the structure is joined to the semi-conductors and insulators by soldering.

12

**12.** A method according to Claim 6, characterised in that the structure is joined to the semi-conductors and insulators by adhesion.

**13.** A method according to Claim 6, characterised in that the encapsulating structure is made by laser braze welding a cover onto a case, the case having previously been fitted with the semi-conductor elements or insulators and the active circuits.

**14.** A method according to Claim 6, characterised in that the components are protected by a product selected from varnishes and resins.

**Patentansprüche**

**1.** Material für elektronische Bauteile, das in wenigstens zwei Richtungen einen Dehnungskoeffizient $\alpha$ zwischen 30 °C und 250 °C im Bereich von 2 bis $13.10^{-6}$ $K^{-1}$, eine Volumenmasse unter 3000 $kg.m^{-3}$ und eine Leitfähigkeit 2 über oder gleich 113 $W.m^{-1}.K^{-1}$ aufweist,
**dadurch gekennzeichnet,**
daß es aus einem Verbundprodukt besteht, das von einer Matrix aus einem unter dem reinen Aluminium, dem reinen Magnesium und deren Legierungen gewählten Metall und Verstärkungselementen gebildet wird, die unter
- den Graphitteilchen gemäß einem Volumenanteil im Bereich von 60 bis 80 %;
- den Siliziumkarbid-, Siliziumnitrid- und Aluminiumnitridteilchen gemäß einem Volumenanteil im Bereich von 40 bis 85 % und mit einer mittleren Teilchengröße im Bereich von 17,3 bis 50 $\mu$m; und
- den kurzen Fasern aus graphitiertem Kohlenstoff in einem Volumenanteil im Bereich von 15 bis 30 % gewählt werden,
wobei das Produkt aus der Infiltration des Verstärkungselements durch das Metall im flüssigen Zustand resultiert.

**2.** Material nach dem Anspruch 1,
dadurch gekennzeichnet,
daß die Aluminiumlegierungen zur Gruppe gehören, die aus den Serien 1000, 4000, 5000 und 6000 gemäß den Normen der Aluminium Association besteht.

**3.** Material nach dem Anspruch 2,
dadurch gekennzeichnet,
daß unter den Legierungen der Serie 4000 die Gußlegierungen mit einem Gehalt von etwa 7, 10 und 13 Gew.% Silizium und die Legierungen AA 356, AA 357 und AA 413.2 eingetragen sind.

**4.** Material nach dem Anspruch 1,
dadurch gekennzeichnet,
daß die Verstärkungselemente aus einer porösen, agglomerierten Vorform von Siliziumkarbidteilchen bestehen.

**5.** Material nach dem Anspruch 1,
dadurch gekennzeichnet,
daß die Verstärkungselemente aus einem Filz oder einer Vorform von kurzen Fasern von graphitiertem Kohlenstoff bestehen.

**6.** Verfahren zur Herstellung elektronischer Bauteile aus Materialien nach dem Anspruch 1,
**dadurch gekennzeichnet,** daß:
- man in einer Form eine poröse Masse von Verstärkungselementen anordnet, die unter den Siliziumkarbid-, Siliziumnitrid- und Aluminiumnitridteilchen gemäß einem Volumenanteil im Bereich von 40 bis 85 % und mit einer mittleren Teilchengröße im Bereich von 17,3 bis 50 $\mu$m, den künstlichen Graphitteilchen gemäß einem Volumenanteil im Bereich von 60 bis 90 % und den kurzen Fasern aus graphitiertem Kohlenstoff in einem Volumenanteil im Bereich von 15 bis 50 % gewählt sind,
- man diese Masse mit dem unter dem reinen Aluminium, dem reinen Magnesium und deren Legierungen gewählten Metall im flüssigen Zustand derart infiltriert, um ein Material zu erhalten, das in wenigstens zwei Richtungen einen Koeffizient $\alpha$ zwischen 30 und 250 °C im Bereich von 2 bis $13.10^{-6}$ $K^{-1}$, eine Volumenmasse unter 3000 kg $m^{-3}$ und eine Leitfähigkeit $\lambda$ über 113 W $m^{-1}$ $K^{-1}$ aufweist,

- man das erhaltene Material nach Erstarrung entnimmt,
- man einen Verbindungs-, Einkapselungs- oder Trägeraufbau herstellt, der wenigstens teilweise aus diesem Material gebildet wird,
- man damit Halbleiterbauelemente oder Isolierstoffe verbindet und
- man die aktiven Kreise positioniert und die Zwischenverbindungen sichert.

7. Verfahren nach dem Anspruch 6,
dadurch gekennzeichnet,
daß die poröse Masse unter den agglomerierten Vorformen von Teilchen, den Filzen aus kurzen Fasern und den aufgespulten Endlosfasern gewählt wird.

8. Verfahren nach dem Anspruch 6,
dadurch gekennzeichnet,
daß man im Fall einer Matrix, die aus einer Legierung der Serie 6000 und der Legierungen AA 356 und AA 357 besteht, das Material einer Wärmebehandlung unterwirft, die unter dem Glühen und dem Anlassen gewählt wird.

9. Verfahren nach dem Anspruch 6,
dadurch gekennzeichnet,
daß man den Aufbau zu den Endmaßen bearbeitet.

10. Verfahren nach dem Anspruch 6,
dadurch gekennzeichnet,
daß man den Aufbau mit einer chemischen und/oder elektrochemischen Nickelschicht überzieht.

11. Verfahren nach dem Anspruch 6,
dadurch gekennzeichnet,
daß man den Aufbau mit den Halbleitern und den Isolierstoffen durch Löten verbindet.

12. Verfahren nach dem Anspruch 6,
dadurch gekennzeichnet,
daß man den Aufbau mit den Halbleitern und den Isolierstoffen durch Kleben verbindet.

13. Verfahren nach dem Anspruch 6,
dadurch gekennzeichnet,
daß man den Einkapselungsaufbau durch Laserschweißlöten eines Deckels auf ein Gehäuse herstellt, das vorher mit den Halbleiterbauelementen oder den Isolierstoffen und den aktiven Kreisen bestückt wurde.

14. Verfahren nach dem Anspruch 6,
dadurch gekennzeichnet,
daß man die Bauteile durch einen unter den Lacken und den Harzen gewählten Stoff schützt.

FIG.1

FIG .2

FIG.3

FIG.4